# EUROPÄISCHE PATENTANMELDUNG

(11) **EP 0 571 860 A1**
(43) Veröffentlichungstag der Anmeldung: **01.12.1993**
(21) Anmeldenummer: 93108018.8
(22) Anmeldetag: 17.05.1993
(51) Int. Cl.: H05K 7/20, H01L 23/473

(54) **Einbausystem für auf Leiterplatten montierte hochintegrierte Bausteine**

(30) Priorität: 27.05.1992 DE 4217596
(71) Anmelder: Siemens Nixdorf Informationssysteme Aktiengesellschaft, D-33102 Paderborn (DE)
(72) Erfinder: Bachl, Johann, W-8000 München 19 (DE)
(74) Vertreter: Fuchs, Franz-Josef, Dr.-Ing.

(57) **Zusammenfassung**

Die Erfindung betrifft ein Einbausystem für auf Leiterplatten montierte hochintegrierte Bausteine mit mehr als 500 Pins und einer Verlustleistung > 50 Watt. Der Baustein (1) wird dabei auf einem Keramikplättchen (2) angeordnet, das auf der dem Baustein (1) zugewandten Seite einen Spider (3) besitzt, der die feine Leadteilung des Bausteins (1) an die gröbere Teilung der Leiterplattenanschlüsse anpaßt. Sowohl die Bauteileanschlüsse als auch die Leiterplattenanschlüsse sind mit dem Spider (3) auf der Keramikplatte (2) verbunden. Der Baustein (1) ist sowohl mit seiner Oberseite als auch mit seiner Unterseite unmittelbar an Wärmesenken angelegt. Um die Kontaktzone des Bausteins (1) mit dem Spider (3) auf dem Keramikplättchen (2) wird ein Keramikrähmchen (11) angeordnet, über das eine Membrane (4) gespannt ist, wobei der dadurch entstehende Hohlraum mit einer inerten Kühlflüssigkeit ausgefüllt ist. Dadurch wird der Baustein allseitig an seiner Oberfläche gekühlt und eine optimale Wärmeableitung erzielt.

## Beschreibung

Die Erfindung betrifft ein Einbausystem für auf Leiterplatten montierte hochintegrierte, gehäuselose Bausteine.

Bei hochintegrierten Bausteinen mit einer Pinzahl > 500 und einer Verlustleistung > 50 Watt fällt pro Flächeneinheit eine erhebliche Wärmemenge an.

Aufgabe der vorliegenden Erfindung ist es daher, ein Einbausystem für auf Leiterplatten montierte hochintegrierte Bausteine mit optimaler Wärmeableitung und einfacher Montierbarkeit der gehäuselosen Bausteine zu schaffen. Zur Lösung dieser Aufgabe sieht die Erfindung vor, daß mindestens ein Baustein auf einem Keramikplättchen angeordnet ist, daß auf dessen, dem Baustein zugewandten Seite ein Spider aufgebracht ist, der die feine Lead-Teilung des Bausteins an die gröbere Teilung der Leiterplattenteilung anpaßt und daß sowohl die Bauteilanschlüsse als auch die Leiterplattenanschlüsse mit dem Spider auf dem Keramikplättchen verbunden sind, daß der Baustein sowohl mit seiner Oberseite als auch mit seiner Unterseite unmittelbar an Wärmesenken anliegt, daß um die Kontaktzone des Bausteins mit dem Spider auf dem Keramikplättchen ein Keramikrähmchen angeordnet ist, über das eine Membrane gespannt ist, und daß der dadurch entstehende Hohlraum mit einer inerten Kühlflüssigkeit ausgefüllt ist.

Eine weitere Ausgestaltung sieht vor, daß der Baustein mit seiner Rückenseite auf dem Keramikplättchen und dieses wiederum auf der Leiterplatte aufliegt, daß der Baustein auf das Keramikplättchen und das Keramikplättchen auf die Leiterplatte aufgebondet ist und daß der Zwischenraum zwischen Anschlußseite des Bausteins und Membran durch ein Leitblech ausgefüllt ist.

Außerdem kann das Einbausystem auch so ausgestaltet sein, daß der Baustein mit seiner Rückenseite auf dem Keramikplättchen aufliegt und auf dieses aufgebondet ist, und der Zwischenraum zwischen Anschlußseite des Bausteins und der Membran durch ein Leitblech ausgefüllt ist, daß zwischen Keramikplättchen und Leiterplatte Druckstücke angeordnet sind und der Spider des Keramikplättchens über einen weiteren Spider mit den Leiterplattenanschlüssen verbunden ist.

Eine weitere Möglichkeit des Aufbaus des Einbausystems besteht darin, daß der Baustein mit seiner Rückenseite an der Membran anliegt, zwischen Anschlußseite des Bausteins und des Keramikplättchens ein Leitblech liegt und der Baustein über einen flachen Spider mit der einen Seite des Spiders des Keramikplättchens verbunden ist.

Eine andere Variante sieht vor, daß der Baustein mit seiner Rückenseite an der Membran anliegt, zwischen Anschlußseite des Bausteins und Keramikplättchen ein Leitblech liegt und der Baustein in Flip-Chip-Technik mit dem Spider des Keramikplättchens verbunden ist.

Durch diese Maßnahmen erhält man ein Einbausystem, bei dem eine optimale Kühlung hochintegrierter Bausteine mit einer Pinzahl > 500 und einer Verlustleistung > 50 Watt erzielt wird, da die Verlustleistung von der gesamten Bausteinoberfläche abgeführt wird.

Bildet man das Keramikplättchen aus Aluminiumnitrid aus, so ist der Ausdehnungskoeffizient etwa gleich den Ausdehnungskoeffizienten des Siliziumbausteins.

Anhand der Ausführungsbeispiele nach den Figuren 1 bis 4 wird die Erfindung näher erläutert. Es zeigen
Figur 1 eine erste Ausführungsform, bei der der Baustein rückseitig auf dem Keramikplättchen aufliegt und der Baustein auf das Keramikplättchen aufgebondet und das Keramikplättchen wiederum auf die Leiterplatte aufgebondet ist,
Figur 2 eine zweite Ausführungsform, bei der der Baustein rückseitig auf das Keramikplättchen aufgelegt und auf dieses aufgebondet ist, wobei die Verbindung des Keramikplättchens mit der Leiterplatte über einen weiteren Spider hergestellt wird,
Figur 3 eine dritte Ausführungsform, bei der der Baustein mit seiner Rückseite an einer Membran anliegt und auf seiner Anschlußseite über ein Leitblech mit dem Keramikplättchen wärmekontaktierend verbunden und über einen flachen Spider mit dem Spider des Keramikplättchens verbunden ist und
Figur 4 eine vierte Ausführungsform, bei der der Baustein in Flip-Chip-Technik auf dem Spider des Keramikplättchens aufgebracht ist.

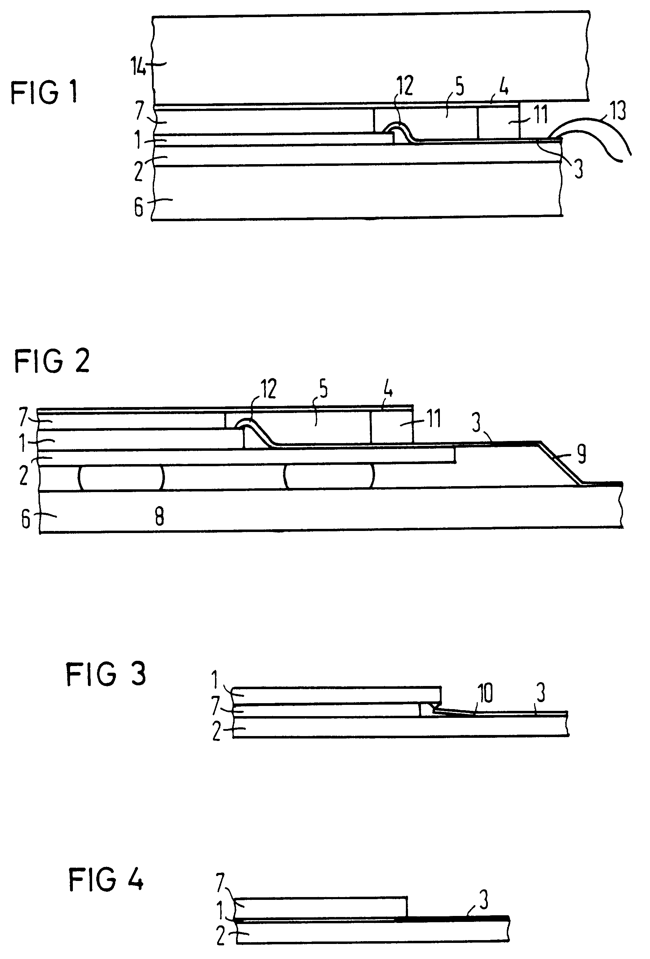

Wie in Figur 1 dargestellt, ist der hochintegrierte Baustein 1 mit seiner Rückenseite auf das Keramikplättchen 2 gut wärmekontaktierend aufgelegt und auf den Spider 3 des Keramikplättchens 2 aufgebondet. Der Spider 3 ist dabei so ausgebildet, daß er die Feinteilung der Bausteinleads in die Grobteilung der Leiterplattenanschlüsse auffächert. Die so entstandene Innerleadbondung 12 des Bausteins mit dem Keramikplättchen ist von dem Keramikrähmchen 11 umgeben, über das flüssigkeitsdicht eine Membran 4 gespannt ist, so daß dadurch ein Hohlraum entsteht, in dem eine inerte Flüssigkeit eingebracht ist. Zwischen Anschlußseite des Bausteins 1 und Membran 4 ist außerdem das Leitblech 7 gelegt, um einen guten Wärmekontakt zwischen Baustein und Membran sicherzustellen. Die Membran 4 ist dann ihrerseits wieder mit einer Wärmesenke kontaktiert. Das Keramikplättchen 2 ist außerdem auf die Leiterplatte 6 aufgebondet. Dadurch ist der Baustein 1 beidseitig wärmeleitend kontaktiert. Als zusätzlicher Kühleffekt dient die inerte Flüssigkeit im verkapselten Hohlraum 5. Je nach Einbaulage des Bausteins muß untersucht werden, ob die Flüssigkeit leitend oder als Siedekühlung wirken soll.

Es kann sich auch als vorteilhaft erweisen, mehrere Bauseine auf einem Keramiktärger unterzubringen, wenn die Verdrahtungsdichte zwischen den Bausteinen 1 mit der Verdrahtungsdichte des Keramikplättchens 2 erfüllt werden kann.

Bei einer Ausführungsform nach Figur 2 ist die Rückenseite des Bausteins 1 wieder auf das Keramikplättchen 2 aufgelegt und auf dieses mit einer Innerleadbondung 12 aufgebondet. Die Outerleadbondung zwischen dem Keramikplättchen 2 und der Leiterplatte 6 erfolgt hierbei über einen weiteren Spider 9. Der Zwischenraum zwischen der Anschlußseite des Bausteins 1 und der Membran 4 ist wiederum durch das Leitblech 7 ausgefüllt. Zwischen Keramikplättchen 4 und Leiterplatte 6 liegen Druckstücke 8, die einen guten Wärmekontakt zwischen Baustein, Kühlplättchen und Membran bewirken sollen.

Eine andere Ausführungsform, wie in Figur 3 dargestellt, sieht vor, daß der Baustein 1 mit seiner Rückenseite an der Membran 4 anliegt und zudem über einen flachen Spider 10 mit dem Spider 3 des Kühlplättchens 2 verbunden ist. Die Flüssigkeitskühlung ist wieder, wie bereits vorher beschrieben, vorgesehen und der Einfachheit halber in diesem Beispiel nicht dargestellt.

Figur 4 zeigt eine andere Möglichkeit der Montage des Bausteins 1, wobei dieser in Flip-Chip-Technik auf den Spider 3 des Keramikplättchens 2 aufgebracht wird.

## Patentansprüche

1. Einbausystem für auf Leiterplatten montierte hochintegrierte, gehäuselose Bausteine, bei dem mindestens ein Baustein auf einem Träger angeordnet ist, wobei auf dessen, dem Baustein zugewandten Seite ein Spider aufgebracht ist, der die feine Lead-Teilung des Bausteins an die gröbere Teilung der Leiterplattenteilung anpaßt und bei dem sowohl die Bauteilanschlüsse als auch die Leiterplattenanschlüsse mit dem Spider auf dem Träger verbunden sind, und bei dem der Baustein mit seiner Oberseite unmittelbar an einer Wärmesenke anliegt, **dadurch gekennzeichnet,** daß der Träger ein Keramikplättchen (2) ist, das als Wärmesenke dient, und an dem der Baustein (1) mit seiner Unterseite unmittelbar anliegt, daß um die Kontaktzone des Bausteins (1) mit dem Spider (3) auf dem Keramikplättchen (2) ein Keramikrähmchen (11) angeordnet ist, über das eine Membrane (4) gespannt ist, und daß der dadurch entstehende Hohlraum (5) mit einer inerten Kühlflüssigkeit ausgefüllt ist.

2. Einbausystem nach Anspruch 1, **dadurch gekennzeichnet,** daß der Baustein (1) mit seiner Rückenseite auf dem Keramikplättchen (2) und dieses wiederum auf der Leiterplatte (6) aufliegt und daß der Baustein (1) auf das Keramikplättchen (2) und das Keramikplättchen (2) auf die Leiterplatte (6) aufgebondet ist, und daß der Zwischenraum zwischen Anschlußseite des Bausteins (1) und Membran (4) durch ein Leitblech ausgefüllt ist.

3. Einbausystem nach Anspruch 1, **dadurch gekennzeichnet,** daß der Baustein (1) mit seiner Rückenseite auf dem Keramikplättchen (2) aufliegt und auf dieses aufgebondet ist, und der Zwischenraum zwischen Anschlußseite des Bausteins (1) und der Membran (4) durch ein Leitblech (7) ausgefüllt ist, daß zwischen Keramikplättchen (2) und Leiterplatte (6) Druckstücke (8) angeordnet sind und der Spider (3) des Keramikplättchens (2) über einen weiteren Spider (9) mit den Leiterplattenanschlüssen verbunden ist.

4. Einbausystem nach Anspruch 1, **dadurch gekennzeichnet,** daß der Baustein (1) mit seiner Rückenseite an der Membran (4) anliegt, zwischen Anschlußseite des Bausteins (1) und Keramikplättchens (2) ein Leitblech (7) liegt und der Baustein (1) über einen flachen Spider (10) mit der einen Seite des Spiders (3) des Keramikplättchens (2) verbunden ist.

5. Einbausystem nach Anspruch 1, **dadurch gekennzeichnet,** daß der Baustein (1) mit seiner Rückenseite an der Membran (4) anliegt, zwischen Anschlußseite des Bausteins (1) und Keramikplättchen (2) ein Leitblech (7) liegt und der Baustein (1) in Flip-Chip-Technik mit dem Spider (3) des Keramikplättchens (2) verbunden ist.

6. Einbausystem nach einem der vorhergehenden Ansprüche, **dadurch gekennzeichnet,** daß das Keramikplättchen (2) aus Aluminiumnitrid (AlN) besteht.
